# EUROPÄISCHE PATENTSCHRIFT

(11) **EP 1 118 263 B1**
(45) Veröffentlichungstag und Bekanntmachung des Hinweises auf die Patenterteilung: **05.06.2002**
(21) Anmeldenummer: 99953695.6
(22) Anmeldetag: 02.09.1999
(51) Int. Cl.: H05K 13/08

(54) **VERFAHREN ZUR STEUERUNG VON AUFEINANDERFOLGENDEN MASCHINENPROZESSEN**
METHOD FOR CONTROLLING SEQUENTIAL MACHINE PROCESSES
PROCEDE DE COMMANDE DE PROCESSUS SUCCESSIFS EFFECTUES PAR UNE MACHINE

(30) Priorität: 30.09.1998 DE 19845110
(43) Veröffentlichungstag der Anmeldung: 25.07.2001
(73) Patentinhaber: SIEMENS AKTIENGESELLSCHAFT, 80333 München (DE)
(72) Erfinder: HUBER, Wolfgang, D-81379 München (DE); HAAS, Gerhard, D-85764 Oberschlei heim (DE); PRÜFER, Martin, D-81379 München (DE)
(86) Internationale Anmeldenummer: DE9902782
(87) Internationale Veröffentlichungsnummer: WO0019801

(56) Entgegenhaltungen:
- US-A- 5 584 118

## Beschreibung

Die Erfindung bezieht sich auf ein Verfahren zur Steuerung von aufeinanderfolgenden Maschinenprozessen, bei dem mindestens eine erste und eine zweite Steuereinheit für die unterschiedlichen Maschinenprozesse untereinander und mit einer Zentrale verbunden sind. Ein solches Verfahren ist zum Beispiel aus US-A-5 584 118 bekannt

Solche aufeinanderfolgenden Maschinenprozesse spielen beispielsweise bei der automatischen Bestückung von Substraten (beispielsweise Leiterplatten oder Keramiksubstraten) mit Bauelementen (beispielsweise SMD-Bauelemente, SMD = Surface Mounted Device, oder Ball-Grid-Arrays = BGA) eine Rolle. Dabei werden die einzelnen Bauelemente mittels eines Bestückkopfes aus einem Magazin oder einer Zuführeinrichtung entnommen und dann in einer vorgegebenen Lage auf dem Substrat positioniert.

Bei diesem Prozeßablauf werden eine große Anzahl (pro Bauelement ungefähr 20 bis 30) von aufeinanderfolgenden Maschinenprozessen durchgeführt, die teilweise erst dann ausgeführt werden dürfen, wenn der zeitlich zuvor ablaufende Maschinenprozeß erfolgreich beendet wurde. Auch bei im Bestückprozeß erforderlichen weiteren Bearbeitungsautomaten wie beispielsweise zum Aufbringen von Klebepunkten auf Substraten kommt es zu solchen Prozeßabläufen. Für die Überwachung dieser erzwungenen Reihenfolge der Machinenprozesse sind die die einzelnen Maschinenprozesse steuernden und überwachenden Steuereinheiten mit einer Zentrale verbunden, die den gesamten Prozeßablauf überwacht. Die einzelne Steuereinheit übermittelt an die Zentrale das Ende des ihr zugewiesenen Maschinenprozesses und die Zentrale übermittelt anschließend einen Startbefehl an die Steuereinheit des nachfolgenden Maschinenprozesses. Da die Zentrale aber mehrere parallel ablaufende Maschinenprozesse steuert und zusätzliche Aufgaben, wie beispielsweise die Kommunikation mit einem Bediener des Bestückautomaten abwickelt, kommt es zu Zeitverzögerungen zwischen dem Empfang des Endesignals der ersten Steuereinheit und dem Senden des Startbefehls an die zweite Steuereinheit. Bei einer großen Anzahl von aufeinanderfolgenden Maschinenprozessen kommt es dabei zu erheblichen Zeitverlusten und damit zu geringeren Bestückleistungen. Zusätzlich benötigt die Kommunikation zwischen den Steuereinheiten und der Zentrale Zeit, die die Bestückleistung reduziert.

Eine Möglichkeit zur Zeitreduzierung wäre die Bereitstellung unterschiedlicher Zentralen für unterschiedliche Aufgaben, beispielsweise einer Zentrale für Steuerungsaufgaben und einer zusätzlichen Zentrale für die Kommunikation zwischen dem Bediener und der Maschinen und für Aufgaben zur Datenaufbereitung. Aber auch die Kommunikation der Zentralen untereinander erfordert einen unerwünschten Zeitaufwand.

Es ist daher die Aufgabe der Erfindung, ein Verfahren anzugeben, welches den Zeitbedarf für die Ausführung aufeinanderfolgender Maschinenprozesse minimiert.

Die Aufgabe wird erfindungsgemäß gelöst durch eine Verfahren der eingangs genannten Art mit den Merkmalen des Anspruchs 1.

Durch diese Ausführung bekommen die Steuereinheiten für nachfolgende Maschinenprozesse die Abhängigkeit vom Zustand der vorherigen Maschinenprozesse als Startbedingung mitgeteilt. Die Steuereinheiten tauschen untereinander, ohne Umweg über die Zentrale, die Erfüllung dieser Startbedingungen aus. Die Zentrale verteilt ihre Aufträge - unter der Annahme des ungestörten Ablaufs - so frühzeitig, daß sie in der jeweiligen Steuereinheit vor Erfüllung der Startbedingungen vorliegen. Die Verzögerung wird nur noch durch die Übertragung zwischen den einzelnen Steuereinheiten bestimmt und ist dementsprechend gering.

Durch die Konzentration verschiedener Aufgaben (Steuerung und Bedienung) in einer Zentrale (und damit auf einem Rechner), die durch die Erfindung ohne Zeitverlust ermöglicht wird, werden sowohl Kosten für die Hardware als auch für die Software gespart. Denn es wird nur eine Zentrale verwendet, für die nur ein Standard-Betriebssystem benutzt wird.

In der vorteilhaften Ausgestaltung gemäß Anspruch 2 werden mehrere Startbedingungen übermittelt. Dadurch können auch Maschinenprozesse, die vor ihrem Start auf die Ergebnisse mehrerer früher ablaufender Maschinenprozesse warten müssen, effektiv berücksichtigt werden.

In vorteilhafter Weise ist in der Zentrale gemäß Anspruch 3 ein Ablaufplan für die Maschinenprozesse abgespeichert und die Zentrale protokolliert den ordnungsgemäßen Ablauf anhand von Rückmeldungen durch die Steuereinheiten. Dadurch ist die Zentrale in der Lage bei auftretenden Fehlern im Prozeßablauf ein Fehlerbehandlungsverfahren einzuleiten.

Besonders einfach gestaltet sich das Verfahren, wenn die Zentrale und die Steuereinheiten gemäß Anspruch 4 durch einen rundspruchfähigen Bus untereinander verbunden sind. Ein rundspruchfähiger Bus besitzt die Eigenschaft, daß alle daran angeschlossenen Peripheriegeräte (Steuereinheiten), die auf dem Bus erfolgende Kommunikation verfolgen und alle für sie selbst relavanten Signale und Befehle auswerten. Damit müssen die Signale und Befehle nicht mehrfach, sondern nur einmal ausgesendet werden.

Die Erfindung wird im folgenden anhand des in den Figuren der Zeichnung dargestellten Ausführungsbeispiels und des Standes der Technik näher erläutert.

Dabei zeigen
- Figur 1: ein Schema der erfindungsgemäßen Verbindung von Steuereinheiten und der Zentrale,
- Figur 2: einen schematischen Zeitablauf des erfindungsgemäßen Verfahrens,
- Figur 3a: einen schematischen Ablauf einer bisherigen Steuerung ohne Bedieneinheit,
- Figur 3b: einen schematischen Ablauf einer bisherigen Steuerung mit Bedieneinheit,
- Figur 4: einen schematischen Zeitablauf einer bisherigen Steuerung und
- Figur 5: ein Struktogramm des erfindungsgemäßen Verfahrens.

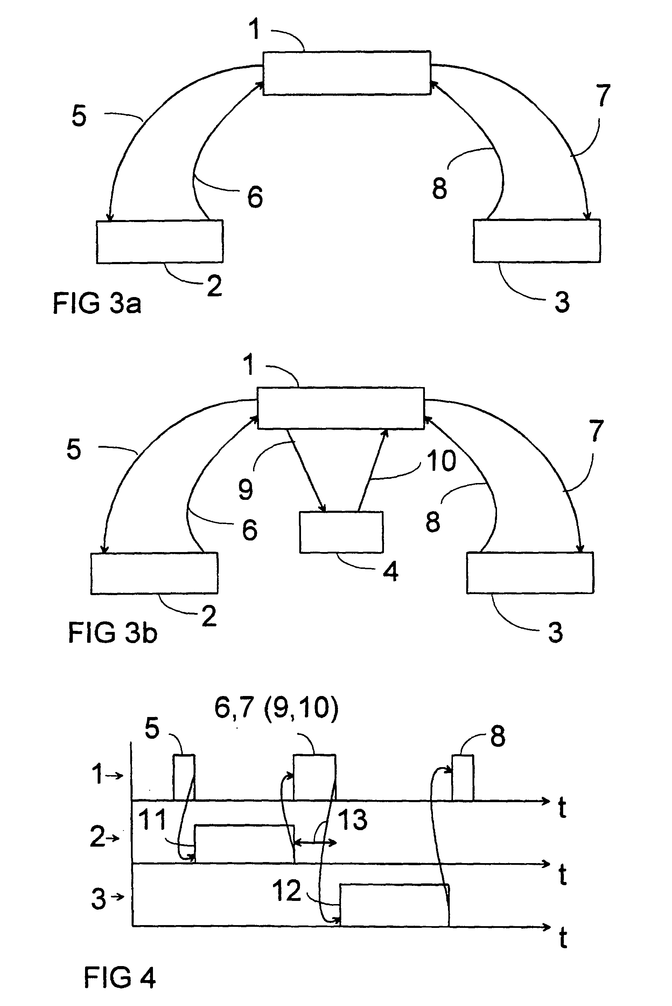

In Figur 3a ist der herkömmliche Ablauf, in Figur 4 der dazugehörige zeitliche Ablauf der Steuerung von mehreren aufeinanderfolgenden Maschinenprozessen dargestellt. Eine Zentrale 1 ist mit einer ersten Steuereinheit 2 und einer zweiten Steuereinheit 3 verbunden, die jeweils dezentral Maschinenprozesse abwickeln. Aufeinanderfolgende Maschinenprozesse können dabei beim Bestückprozeß beispielsweise das Anfahren einer Position durch den Bestückkopf, das Absenken der Saugpipette, das Hochfahren der Saugpipette, die Drehung des Bestückkopfes, die Aufnahme des Bauelements durch eine Kamera, das Anfahren der vorgegebenen Position auf dem Substrat, das Absenken der Saugpipette, das Abschalten des Vakuums und das Hochfahren der Saugpipette sein. Diese Beispiele sind nur exemplarisch zu verstehen. Beliebige, dem Fachmann geläufige, andere Maschinenprozesse beim Bestücken oder auch beim Setzen von Klebepunkten werden ebenfalls durch das erfindungsgemäße Verfahren miteinander gekoppelt. Auch für weitere dem Fachmann geläufige Automatisierungsverfahren ist das erfindungsgemäße Verfahren geeignet.

Der Prozeß läuft herkömmlicherweise nun folgendermaßen ab (Figur 3a, Figur 4):
Die Zentrale 1 übermittelt an die erste Steuereinheit 2 einen Startbefehl 5 für den ersten Maschinenprozeß 11, die erste Steuereinheit 2 wickelt den ersten Maschinenprozeß 11 ab, nach Beendigung des ersten Maschinenprozeß 11 übermittelt die erste Steuereinheit 2 eine Endemeldung 6 an die Zentrale 1. Die Zentrale 1 sendet nach Erhalt der Endemeldung 6 einen Startbefehl 7 für den zweiten Maschinenprozeß 12 an die zweite Steuereinheit 3, diese wickelt den zweiten Maschinenprozeß 12 ab und sendet nach der Abwicklung eine Endemeldung 8 an die Zentrale 1. Dieses Verfahren kann beliebig fortgesetzt werden, bis der gesamte Prozeßablauf komplett abgewickelt ist. Aufgrund der Kommunikation über die Zentrale kommt es zu einer unerwünschten Zeitverzögerung 13 zwischen dem Ende des ersten und dem Start des zweiten Maschinenprozesses. Durch die Laufzeiten der Signale zwischen den Steuereinheiten 2,3 und der Zentrale 1 kommt es zu weiteren unerwünschten Zeitverlusten.

Wie in Figur 3b dargestellt ist, kommuniziert die Zentrale 1 häufig zusätzlich mit weiteren Peripherieeinheiten, wie beispielsweise einer Bedienungseinheit 4, über die ein Bediener in den Prozeßablauf eingreifen kann, oder über die Prozeßdaten für den Bediener visualisiert werden. Die Startbefehle 9 und Endemeldungen 10 für den Bedienprozeß stören die Steuerung der Steuereinheiten 2,3. Wenn die Zentrale 1 erst noch einen Bedienprozeß abwickeln muß, kommt es zu einer gegenüber dem ersten Beispiel weiteren unerwünschten Zeitverzögerung 13 zwischen dem Ende des ersten Maschinenprozesses 11 und dem Start des zweiten Maschinenprozesses 12.

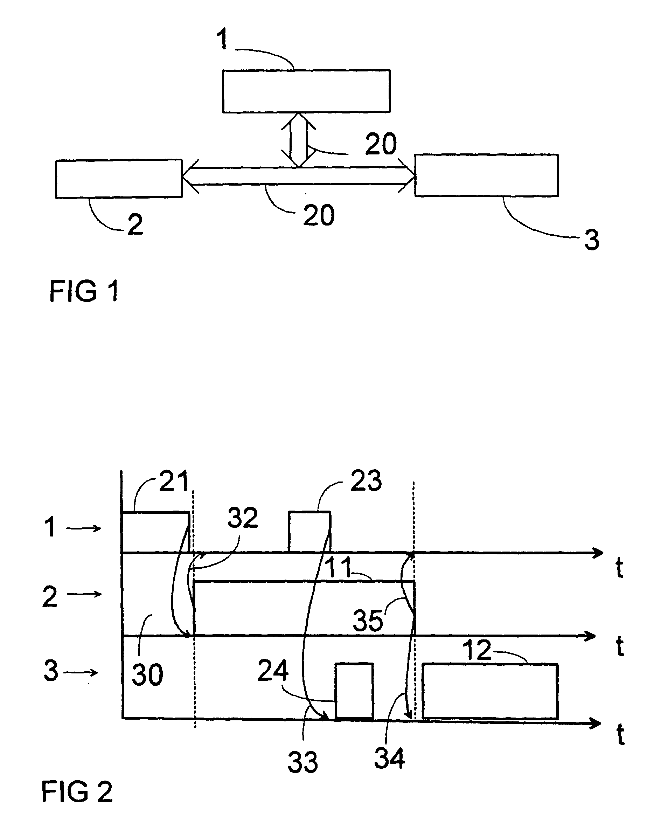

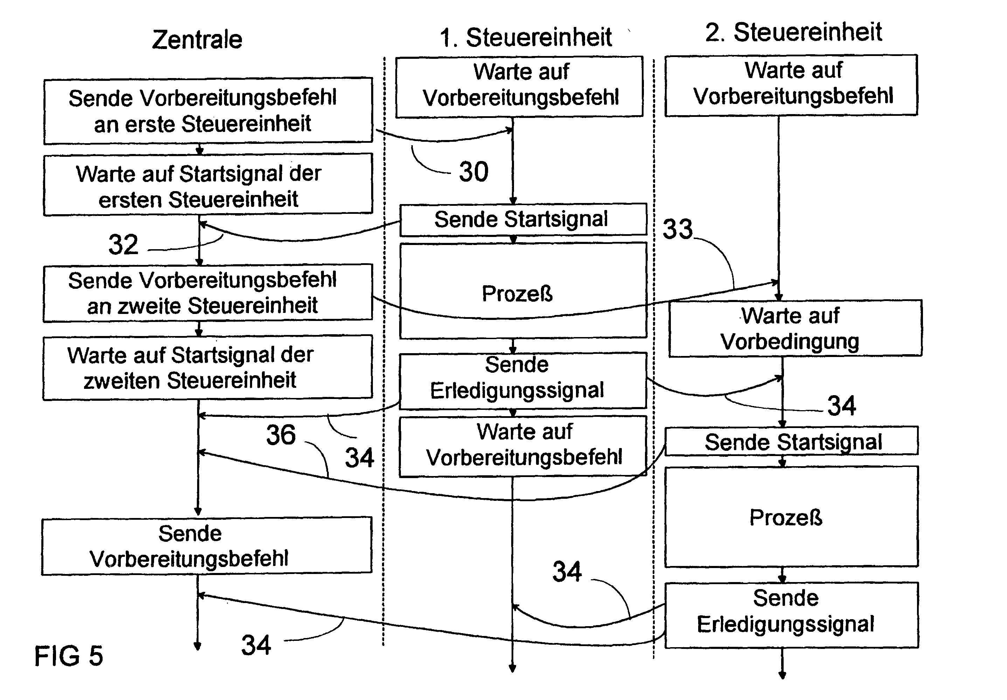

Das erfindungsgemäße Verfahren ist in den Figuren 1 und 2 sowie im Struktogramm in Figur 5 dargestellt. Dabei sind die Zentrale 1 und die Steuereinheiten 2,3 über einen rundspruchfähigen Bus 20 untereinander verbunden.

Die Zentrale 1 übermittelt zum Start des Prozeßablaufs einen Vorbereitungsbefehl 30 an die erste Steuereinheit 2. Anschließend wird der erste Maschinenprozeß 11 ausgeführt. Der Start des ersten Maschinenprozesses 11 wird an die Zentrale 1 mit einem Startsignal 32 übermittelt . Die Zentrale 1 übermittelt während der Laufzeit des ersten Maschinenprozesses 11 einen Vorbereitungsbefehl 23, 33 an die zweite Steuereinheit 3. Der empfangene Vorbereitungsbefehl 24 führt nun nicht sofort zur Ausführung des zweiten Maschinenprozesses 12, sondern enthält eine Startbedingung. Nach Ablauf des ersten Maschinenprozesses 11 übermittelt die erste Steuereinheit 2 ein Erledigungssignal 34 direkt an die zweite Steuereinheit 3, so daß deren Startbedingung erfüllt ist. Daraufhin startet die zweite Steuereinheit 3 den zweiten Maschinenprozeß 12.

Dieses Verfahren kann auch auf mehrere Maschinenprozesse ausgedehnt werden. Auch die Übermittlung mehrerer Startbedingungen an die zweite Steuereinheit 3 ist vorgesehen. Vor dem Start des zweiten Maschinenprozesses 12 müssen dann die entsprechenden Erledigungssignale 34 von weiteren, in Figur 2 und Figur 5 nicht dargestellten, Steuereinheiten empfangen werden.

Die Zentrale 1 überwacht den Prozeßablauf, in dem der Start und das Ende der jeweiligen Maschinenprozesse von den Steuereinheiten 2,3 an die Zentrale 1 übermittelt werden. Die Zentrale 1 vergleicht den Prozeßablauf mit einem abgespeicherten Ablaufplan und startet ein Fehlerbehandlungsverfahren, sobald ein Fehler auftritt (beispielsweise eine über eine vorgegebene Zeitspanne nicht erfolgte Endemeldung oder ein nicht erfolgtes Erledigungssignal). Beispielsweise wird im Rahmen eines Fehlerbehandlungsverfahrens ein Bauelement von der Saugpipette abgeworfen und ein neues Bauelement aufgenommen.

Durch das erfindungsgemäße Verfahren wird nur eine Zentrale 1 dazu verwendet, sowohl Steuerungs- als auch Kommunikationsaufgaben durchzuführen, ohne daß damit ein Zeitverlust zwischen einzelnen Maschinenprozessen auftritt. Für diese eine Zentrale 1 wird auch nur ein Standard-Betriebssystem verwendet, im Gegensatz zu Einzelrechnerlösungen, die spezielle Rechner für Steuerungs- und Kommunikationsaufgaben vorsehen.

## Patentansprüche

1. Verfahren zur Steuerung von aufeinanderfolgenden Maschinenprozessen (11,12), insbesondere in einem Bearbeitungsautomaten zum Bestücken von Substraten mit Bauelementen, bei dem mindestens eine erste Steuereinheit (2) für einen ersten Maschinenprozeß (11) und eine zweite Steuereinheit (3) für einen zweiten Maschinenprozeß (12) untereinander und mit einer Zentrale (1) verbunden sind, bei dem
die Zentrale (1) an die erste Steuereinheit (2) einen Startbefehl (21) für den ersten Maschinenprozeß (11) sendet, die erste Steuereinheit (2) den ersten Maschinenprozeß (11) startet und ein Startsignal (32) an die Zentrale (1) überträgt,
die Zentrale (1) während der Dauer des ersten Maschinenprozesses (11) an die zweite Steuereinheit (3) einen Vorbereitungsbefehl (23,24,33) und dabei mindestens eine Startbedingung für den zweiten Maschinenprozeß (12) übermittelt, die erste Steuereinheit (2) nach Beendigung des ersten Maschinenprozesses (11) ein Erledigungssignal (34) als Erfüllung der Startbedingung an die zweite Steuereinheit (3) übermittelt,
die zweite Steuereinheit (3) den zweiten Maschinenprozeß (12) nach Empfang des Erledigungssignals (34) startet.

2. Verfahren zur Steuerung von aufeinanderfolgenden Maschinenprozessen (11,12) nach Anspruch 1,
**dadurch gekennzeichnet,**
**daß** die Zentrale (1) an die zweite Steuereinheit (3) mit dem Vorbereitungsbefehl (23,24,33) mehrere Startbedingungen für den zweiten Maschinenprozeß (12) überträgt,
**daß** die zweite Steuereinheit (3) durch Kommunikation mit weiteren Steuereinheiten (beispielsweise 2) die Erfüllung der Startbedingungen überprüft und
**daß** die zweite Steuereinheit (3) nach Erfüllung aller Startbedingungen den zweiten Maschinenprozeß (12) startet.

3. Verfahren zur Steuerung von aufeinanderfolgenden Maschinenprozessen (11,12) nach einem der Ansprüche 1 oder 2,
**dadurch gekennzeichnet,**
**daß** in der Zentrale (1) ein Ablaufplan für die Maschinenprozesse (11,12) abgespeichert ist,
**daß** die Zentrale (1) die Erledigungssignale (34), die die Steuereinheiten (2,3) untereinander austauschen, zur Protokollierung der aktuell laufenden Maschinenprozesse (11,12) überwacht und
**daß** die Zentrale (1) bei einer Abweichung zwischen dem abgespeicherten Ablaufplan und dem aktuellen Maschinenprozeß (11,12) ein Fehlerbehandlungsverfahren einleitet.

4. Verfahren zur Steuerung von aufeinanderfolgenden Maschinenprozessen (11,12) nach einem der Ansprüche 1 bis 3,
**dadurch gekennzeichnet,**
**daß** die Steuereinheiten (2,3) und die Zentrale (3) durch einen rundspruchfähigen Bus (20) untereinander verbunden werden.

## Claims

1. Method for controlling successive machine processes (11, 12), in particular in an automatic processing machine for fitting components on substrates, in which at least one first control unit (2) for a first machine process (11) and a second control unit (3) for a second machine process (12) are connected to one another and to a central control station (1), in which
the central control station (1) transmits a start instruction (21) for the first machine process (11) to the first control unit (2),
the first control unit (2) starts the first machine process (11) and transmits a start signal (32) to the central control station (1), the central control station (1) transmits, over the duration of the first machine process (11), a preparation instruction (23, 24, 33) and, at the same time, at least one start condition for the second machine process (12) to the second control unit (3),
the first control unit (2) transmits, after the first machine process (11) has finished, a completion signal (34) as fulfilment of the start condition to the second control unit (3),
the second control unit (3) starts the second machine process (12) after receiving the completion signal (34).

2. Method for controlling successive machine processes (11, 12) according to Claim 1,
**characterized**
**in that** the central control station (1) transmits a plurality of start conditions for the second machine process (12) to the second control unit (3) with the preparation instruction (23, 24, 33),
**in that** the second control unit (3) checks that the start conditions have been fulfilled by communicating with other control units (for example 2), and in that the second control unit (3) starts the second machine process (12) when all the start conditions have been fulfilled.

3. Method for controlling successive machine processes (11, 12) according to one of Claims 1 or 2,
**characterized**
**in that** the central control station (1) stores a cycle plan for the machine processes (11, 12),
**in that** the central control station (1) monitors the completion signals (34) which the control units (2, 3) exchange with one another for the purposes of recording the machine processes (11, 12) which are currently running, and
**in that** the central control station (1) initiates a fault handling procedure if there is a discrepancy between the stored cycle plan and the current machine process (11, 12).

4. Method for controlling successive machine processes (11, 12) according to one of Claims 1 to 3,
**characterized**
**in that** the control units (2, 3) and the central control station (3) are connected to one another by an intercommunicating bus (20).

## Revendications

1. Procédé de commande de processus successifs (11, 12) effectués par une machine, notamment dans un automate de façonnage pour équiper un substrat de composants, dans lequel au moins une première unité de commande (2) pour un premier processus (11) et une deuxième unité de commande (3) pour un deuxième processus (12) sont reliées entre elles et à une centrale (1), dans lequel
la centrale (1) envoie à la première unité de commande (2) une instruction de démarrage (21) pour le premier processus (11), la première unité de commande (2) démarre le premier processus (11) et transmet un signal de démarrage (32) à la centrale (1),
la centrale (1), pendant la durée du premier processus (11), transmet à la deuxième unité de commande (3) une instruction de préparation (23, 24, 33) et en même temps au moins une condition de démarrage pour le deuxième processus (12),
la première unité de commande (2), à la fin du premier processus (11), transmet à la deuxième unité de commande (3) un signal d'exécution (34) indiquant que la condition de démarrage est remplie,
la deuxième unité de commande (3) démarre le deuxième processus (12) après réception du signal d'exécution (34).

2. Procédé de commande de processus successifs (11, 12) effectués par une machine selon la revendication 1, **caractérisé**
**en ce que** la centrale (1) transmet à la deuxième unité de commande (3), en même temps que l'instruction de préparation (23, 24, 33), plusieurs conditions de démarrage pour le deuxième processus (12),
**en ce que** la deuxième unité de commande (3), par communication avec d'autres unités de commande (par exemple 2), vérifie que les conditions de démarrage sont remplies et
**en ce que** la deuxième unité de commande (3), une fois toutes les conditions de démarrage remplies, démarre le deuxième processus (12).

3. Procédé de commande de processus successifs (11, 12) effectués par une machine selon l'une des revendications 1 ou 2, **caractérisé**
**en ce qu'**un organigramme des processus (11, 12) est stocké dans la centrale (1),
**en ce que** la centrale (1) surveille les signaux d'exécution (34) que les unités de commande (2, 3) échangent entre elles, en vue de consigner les processus (11, 12) actuellement en cours et
**en ce que** la centrale (1), en cas d'écart entre l'organigramme stocké et le processus (11, 12) actuel, déclenche une procédure de traitement d'erreurs.

4. Procédé de commande de processus successifs (11, 12) effectués par une machine selon l'une des revendications 1 à 3, **caractérisé en ce que** les unités de commande (2, 3) et la centrale (1) sont reliées entre elles par un bus (20) autorisant la diffusion générale.
